# EUROPÄISCHE PATENTSCHRIFT

(11) **EP 3 571 748 B1**
(45) Veröffentlichungstag und Bekanntmachung des Hinweises auf die Patenterteilung: **15.06.2022**
(21) Anmeldenummer: 18716965.1
(22) Anmeldetag: 03.04.2018
(51) Int. Cl.: H02H 3/16, H02H 9/08, H02H 3/33, H02H 3/38, G01R 31/08

(54) **VERFAHREN ZUR IDENTIFIKATION EINES VON EINEM ERDSCHLUSSFEHLER BEHAFTETEN ABGANGES EINES DREHSTROMNETZES**
METHOD FOR IDENTIFYING AN OUTGOING CIRCUIT HAVING AN EARTH FAULT IN A THREE-PHASE POWER SUPPLY SYSTEM
PROCÉDÉ D'IDENTIFICATION D'UNE DÉRIVATION SUJETTE À UN DÉFAUT DE FUITE À LA TERRE D'UN RÉSEAU ÉLECTRIQUE TRIPHASÉ

(30) Priorität: 25.04.2017 AT 503332017
(43) Veröffentlichungstag der Anmeldung: 27.11.2019
(73) Patentinhaber: Siemens Energy Global GmbH & Co. KG, 81739 München (DE)
(72) Erfinder: AIGNER, Markus, 4651 Stadl-Paura (AT); SCHINERL, Thomas, 4063 Hörsching (AT); OSTERKORN, Harald, 4221 Steyregg (AT)
(86) Internationale Anmeldenummer: PCT/EP2018/058397
(87) Internationale Veröffentlichungsnummer: WO 2018/197162

(56) Entgegenhaltungen:
- EP-A1- 1 526 621
- DE-A1-102009 020 908
- DE-B3- 10 302 451
- GERNOT DRUML ET AL: "Control of Petersen Coils", INTERNATIONAL SYMPOSIUM ON THEORETICAL ELECTRICAL ENGINEERING, XX, XX, Nr. 11th, 1. August 2001 (2001-08-01), Seiten 1-7, XP002678826,

## Beschreibung

### Technisches Gebiet

Die Erfindung betrifft ein Verfahren zur Identifikation eines von einem wiederzündenden oder intermittierenden Erdschlussfehler behafteten Abganges eines Drehstromnetzes.

### Stand der Technik

Erdschlüsse stellen die häufigsten Fehler in Mittelspannungsnetzen dar. Sie werden beispielsweise durch Kabelbeschädigungen, das Hineinwachsen eines Baumes in eine Freileitung, Windschäden oder durch fehlerhafte Isolation der Anlage ausgelöst. Die physikalischen Grundlagen des Erdschlusses sowie Verfahren zu seiner Ortung und Löschung mittels Petersen-Spulen werden in *"*Druml, Gernot. Innovative Methoden ruml, Gernot. Innovative Methoden zur Erdschlussortung und Petersen-Spulen Regelung. na, 2012*."* beschrieben.

Eine besondere Herausforderung sind dabei wiederzündende oder intermittierende Erdschlüsse. Diese treten vor allem in Drehstromnetzen auf, bei denen der Sternpunkt des Transformators über eine Petersen-Spule geerdet ist.

Aus der EP 1 526 621 B1 ist ein Verfahren zur Erkennung eines von einem intermittierenden Erdschlussfehlers befallenen Abganges einer Sammelschiene eines Drehstromnetzes bekannt, bei dem jedes Auftreten eines transienten Erdschlusses auf einem Abgang detektiert und aus den Auftritten ein Kriterium gewonnen wird, welches einen Abgang als von einem intermittierenden Erdschlussfehler befallen anzeigt.

Gemäß der Lehre dieser Schrift wird für jeden Abgang periodisch ein Messwert ermittelt, der pro Periode:
- bei Auftreten eines transienten Erdschlusses auf diesem Abgang um einen ersten Wert bis maximal zu einem oberen Grenzwert erhöht wird,
- bei Auftreten eines transienten Erdschlusses auf einem anderen Abgang um den ersten Wert bis minimal zu einem unteren Grenzwert erniedrigt wird, und
- bei Ausbleiben eines transienten Erdschlusses um einen zweiten, kleineren Wert in Richtung Null verändert wird, wobei ein Abgang als befallen angezeigt wird, wenn der Messwert dieses Abganges einen Schwellwert überschreitet, der größer als der erste Wert und kleiner gleich dem oberen Grenzwert ist.

Die DE 10 302 451 B3 beschreibt ein Verfahren zur Erkennung der Richtung aus der Aufladeschwingung von einmalig zündenden, wiederzündenden und intermittierenden Erdschlüssen, bei dem ein Erdschluss festgestellt wird, wenn der Betrag der Nullspannung einen vorgegebenen Grenzwert überschreitet bei dem weiterhin Ladezustände der Abgänge und aus dem Verlauf der Ladezustände die von einem Erdschluss betroffenen Abgänge ermittelt werden.

DE102009020908 A1 bezieht sich auf die selektive Erfassung von nieder- und hochohmigen einmalig zündenden, wiederzündenden und intermittierenden Erdschlüssen in strahlen-, ringförmigen oder vermaschten Wechsel- und Drehstromnetzen mit isoliertem Sternpunkt oder mit nieder- bzw. hochohmig geerdetem Sternpunkt.

Der vorliegenden Erfindung liegt die Aufgabe zugrunde, den Stand der Technik weiterzuentwickeln.

### Darstellung der Erfindung

Diese Aufgabe wird gelöst mit einem Verfahren gemäß Anspruch 1.

Vorteilhafte Ausgestaltungen ergeben sich aus den Unteransprüchen.

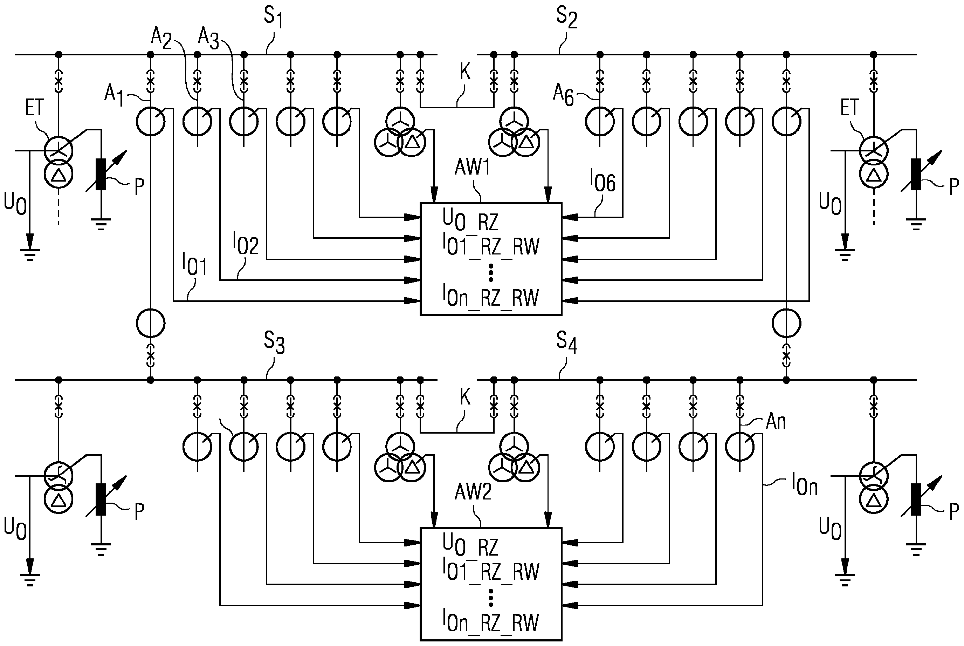

### Kurze Beschreibung der Figur

Die Erfindung wird anhand eines in der Figur schematisch dargestellten beispielhaften Mittelspannungsdrehstromnetzes näher erläutert.

### Ausführung der Erfindung

Ein Mittelspannungsdrehstromnetz, wie es beispielhaft in der Figur dargestellt ist, dient typischerweise der elektrischen Energieversorgung einer Region, die mehrere Ortschaften, oder in Städten einen Stadtteil, umfasst.

Die Knoten des Netzes werden durch Sammelschienen S gebildet, mit denen über Schaltgeräte die Abgänge A₁, A₂,...Aₙ, d.h. die Abzweigungen zu Verbrauchern, sowie Einspeisungen und Kupplungen zu anderen Netzknoten verbunden sind.

Die Einspeisung erfolgt beim dargestellten Beispiel mittels Einspeisetransformatoren ET aus übergeordneten Hochspannungsnetzen.

Die sekundärseitigen Sternpunkte der Einspeisetransformatoren ET sind über eine sogenannte Petersen-Spule P oder Erdschlusslöschspule mit dem Erdpotential verbunden, sodass bei nicht beabsichtigten Erdschlüssen eines Außenleiters die kapazitiven Erdschlussströme kompensiert und an der Fehlerstelle die Fehlerspannung reduziert werden, wie es beispielsweise in *"*Druml, Gernot. Innovative Methoden zur Erdschlussortung und Petersen-Spulen Regelung. na, 2012*."* beschrieben ist.

Die Erdschlusskompensation erfolgt in jedem Teilnetz des über Kupplungen K aufgeteilten Mittelspannungsnetzes.

Die automatische Abstimmung der einstellbaren Petersen-Spulen kann beispielsweise mittels Erdschlusskompensationsregler des Typs EFC50 und EFC50i der Trench Austria GmbH erfolgen.

Das genannte Unternehmen bietet auch Geräte des Typs EFD 500 zur Erkennung von Erdschlüssen an. Dazu erfolgt eine Erfassung und Auswertung der an der Petersen-Spule P auftretenden Nullspannung U₀ des Mittelspannungsnetzes sowie die Nullströme I₀₁, I₀₂, ...I₀ₙ der Abgänge A₁, A₂,...Aₙ.

Erfindungsgemäß werden nun mittels Auswertegeräten AW1, AW2 zur Identifikation eines von einem Erdschlussfehler behafteten Abganges eines Drehstromnetzes, die zu periodisch wiederkehrenden Zeitpunkten gemessenen und gespeicherten Werte der an einem Sternpunkt bzw. einer Petersen-Spule auftretenden Nullspannung U₀ mittels Transformation in eine Raumzeigerdarstellung der Nullspannung U_{0_RZ} und die Nullströme I₀₁, I₀₂,..., I₀ₙ der Abgänge A₁, A₂,..., Aₙ in eine Wirkkomponente der Raumzeigerdarstellung der Nullströme I_{01_RZ_WK}, I_{02_RZ_WK},..., I_{0n_RZ_WK} bezogen auf die Raumzeigerdarstellung der Nullspannung U_{0_RZ} umgewandelt.

Die Raumzeigerdarstellung, wie sie in *"*Druml, Gernot. Innovative Methoden zur Erdschlussortung und Petersen-Spulen Regelung. na, 2012*."* beschrieben ist, führt zu einer anschaulichen Darstellung transienter Vorgänge.

Nach Feststellung eines Erdschlusses zu einem ersten Zeitpunkt t₁ mittels bekannter Verfahren, wie sie beispielsweise auch von den oben angeführten Geräten des Typs EFD 500 verwendet werden, wird ein zweiter Zeitpunkt t₂ ermittelt, zu dem die Raumzeigerdarstellung der Nullspannung U_{0_RZ} ein lokales Minimum aufweist. Danach wird ein dritter Zeitpunkt t₃ bestimmt, zu dem die Raumzeigerdarstellung der Nullspannung U_{0_RZ} ein lokales Maximum aufweist.

In dem Zeitraum zwischen dem zweitem Zeitpunkt t₂ und dem drittem Zeitpunkt t₃ wird die Trapezsumme der Wirkkomponente der Raumzeigerdarstellung der Nullströme I_{01_RZ_WK}, I_{02_RZ_WK},..., I_{0n_RZ_WK} ermittelt und daraus der mit dem Erdschluss behaftete Abgang bestimmt.

Dies geschieht in der Weise, dass die Trapezsumme der Wirckomponente der Raumzeigerdarstellung der Nullströme I_{01_RZ_WK}, I_{02_RZ_WK},..., I_{0n_RZ_WK} mit einem vorgegebenen variablen Schwellwert verglichen und bei Überschreitung dieses Schwellwertes ein Erdschluss festgestellt wird.

Der Schwellwert wird adaptiv an die Gesamtkapazität der an einer Sammelschiene angeschlossenen Abgänge angepasst und bewirkt damit die Berücksichtigung sich ändernder Netzgrößen. Er kann beispielsweise als bestimmter Prozentwert der gesamten Netzkapazität eingestellt werden.

Die Bestimmung der Netzkapazität kann mit bekannten Verfahren erfolgen, wie sie beispielsweise in den Geräten des Typs EFC50 und EFD500 der Trench Austria GmbH angewendet werden.

Diese adaptive Anpassung des Schwellwertes hat den Vorteil, dass das Verfahren zuverlässiger wird.

Eine weitere Erhöhung der Zuverlässigkeit des Verfahrens wird dadurch erreicht, dass das Verfahren abgebrochen wird, wenn der Betrag der Raumzeigerdarstellung der Nullspannung U_{0_RZ} einen vorgegebenen Bereich übersteigt.

Damit werden die physikalischen Grenzen der Messgeräte berücksichtigt, die andernfalls zu fehlerhaften Ergebnissen führen könnten.

Das Ausführungsbeispiel zeigt ein gelöschtes Netz mit Petersen-Spulen P. Die Erfindung ist aber gleichermaßen auch bei ungelöschten Netzen anwendbar. In diesen Fällen muss zur Bestimmung des adaptiven Schwellwertes die Netzkapazität beispielsweise über Kabeldaten und Schaltzustände ermittelt werden.

### Bezugszeichenliste:

- P: Petersen-Spule
- K: Kupplung
- ET: Einspeisungstransformator
- A₁, A₂, ...Aₙ: Abgänge
- I₀₁, I₀₂, ...I₀ₙ: Nullstöme der Abgänge
- U₀: Nullspannung
- S₁, S₂, S₃, S₄: Sammelschienen
- AW1, AW2: Auswertegerät

## Patentansprüche

1. Verfahren zur Identifikation eines von einem Erdschlussfehler behafteten Abganges eines Drehstromnetzes, wobei die an einem Sternpunkt auftretende Nullspannung (U₀) und die Nullströme (I₀₁, I₀₂,..., I₀ₙ) der Abgänge (A₁, A₂,..., Aₙ) zu periodisch wiederkehrenden Zeitpunkten gemessen und gespeichert werden, **dadurch gekennzeichnet,**
**dass**
mittels Transformation eine Raumzeigerdarstellung der Nullspannung(U_{0_RZ}) und eine Wirkkomponente der Raumzeigerdarstellung der Nullströme (I_{01_RZ_WK}, I_{02_RZ_WK},..., I_{0n_RZ_WK}) bezogen auf die Raumzeigerdarstellung der Nullspannung(U_{0_RZ}) ermittelt wird, dass nach Feststellung eines Erdschlusses zu einem ersten Zeitpunkt(t₁) ein zweiter Zeitpunkt(t₂) ermittelt wird, zu dem die Raumzeigerdarstellung der Nullspannung(U_{0_RZ} ) ein lokales Minimum aufweist und danach ein dritter Zeitpunkt(t₃) bestimmt wird, zu dem die Raumzeigerdarstellung der Nullspannung (U_{0_RZ} ) ein lokales Maximum aufweist, dass zwischen zweitem Zeitpunkt (t₂) und drittem Zeitpunkt (t₃) die Trapezsumme der Wirkkomponente der Raumzeigerdarstellung der Nullströme (I_{01_RZ_WK}, I_{02_RZ_WK},..., I_{0n_RZ_WK}) ermittelt und daraus der mit dem Erdschluss behaftete Abgang in der Weise bestimmt wird, dass die Trapezsumme der Wirkkomponente der Raumzeigerdarstellung der Nullströme (I_{01_RZ_WK}, I_{02_RZWK},..., I_{0n_RZ_WK}) mit einem vorgegebenen variablen Schwellwert verglichen und bei Überschreitung dieses Schwellwertes ein Erdschluss festgestellt wird.

2. Verfahren nach Anspruch 1, **dadurch gekennzeichnet, dass** die Feststellung eines Erdschlusses erfolgt, wenn der Betrag der Raumzeigerdarstellung der Nullspannung (U_{0_RZ}) einen vorgegebenen Grenzwert überschreitet.

3. Verfahren nach Anspruch 1 oder 2, **dadurch gekennzeichnet, dass** die Raumzeigerdarstellung der Nullspannung (U_{0_RZ}) und der Wirkkomponente der Raumzeigerdarstellung der Nullströme (I_{01_RZ_WK}, I_{02_RZ_WK},..., I_{0n_RZ_WK}) erst ab dem ersten Zeitpunkt(t₁) gespeichert werden.

4. Verfahren nach einem der vorhergehenden Ansprüche, **dadurch gekennzeichnet, dass** die Differenz von lokalem Minimum und lokalem Maximum der Raumzeigerdarstellungen der Nullspannung(U_{0_RZ} ) einen vorgegebenen Mindestwert aufweisen muss.

5. Verfahren nach einem der vorhergehenden Ansprüche, **dadurch gekennzeichnet, dass** das Verfahren abgebrochen wird, wenn der Betrag der Raumzeigerdarstellung der Nullspannung(U_{0_RZ}) einen vorgegebenen Bereich übersteigt.

6. Verfahren nach einem der vorhergehenden Ansprüche, **dadurch gekennzeichnet, dass** die Trapezsumme mit einer Gewichtsfunktion bewertet wird, dass die Gewichtsfunktion bei Auftreten eines Erdschlusses auf dem entsprechenden Abgang (A₁, A₂,..., Aₙ) um einen ersten Wert bis maximal zu einem oberen Grenzwert erhöht wird, dass bei Auftreten eines transienten Erdschlusses auf einem anderen Abgang(A₁, A₂,..., Aₙ) die Gewichtsfunktion um den ersten Wert bis minimal zu einem unteren Grenzwert erniedrigt wird, und dass bei Ausbleiben eines transienten Erdschlusses um einen zweiten, kleineren Wert in Richtung Null verändert wird, wobei ein Abgang (A₁, A₂,..., Aₙ) als befallen angezeigt wird, wenn die mit einer Gewichtsfunktion bewertete Trapezsumme dieses Abganges einen Schwellwert überschreitet.

7. Verfahren nach einem der vorhergehenden Ansprüche, **dadurch gekennzeichnet, dass** der variable Schwellwert aus der Gesamtkapazität der an einer Sammelschiene angeschlossenen Abgänge (A₁, A₂,..., Aₙ) ermittelt wird.

8. Verfahren nach Anspruch 7, **dadurch gekennzeichnet, dass** der variable Schwellwert als bestimmter Prozentwert der Gesamtkapazität der an einer Sammelschiene (S₁, S₂, S₃, S₄) angeschlossenen Abgänge (A₁, A₂,..., Aₙ) festgelegt wird.

## Claims

1. Method for identifying an outgoing circuit having an earth fault in a three-phase power supply system, wherein the zero voltage (U₀) occurring at a neutral point and the zero currents (I₀₁, I₀₂, ... I₀ₙ) of the outgoing circuits (A₁, A₂,..., Aₙ) are measured and stored at periodically recurring times, **characterised in that** a space vector representation of the zero voltage (U_{0_RZ}) and an active component of the space vector representation of the zero currents (I_{01_RZ_WK}, I₀₂__{RZ_WK},..., I_{0n_RZ_WK}) are determined on the basis of the space vector representation of the zero voltage (U_{0_RZ}) by means of transformation, **in that** after an earth fault has been determined at a first time (t₁), a second time (t₂) at which the space vector representation of the zero voltage (U_{0_RZ}) has a local minimum is determined and subsequently a third time (t₃) at which the space vector representation of the zero voltage (U_{0_RZ}) has a local maximum is determined, **in that** the trapezoidal sum of the active component of the space vector representation of the zero currents (I_{01_RZ_WK}, I_{02_RZ_WK},..., I_{0n_RZ_WK}) is determined between a second time (t₂) and a third time (t₃) and is used to determine the outgoing circuit having the earth fault such that the trapezoidal sum of the active component of the space vector representation of the zero currents (I_{01_RZ_WK}, I_{02_RZ_WK},..., I_{0n_RZ_WK}) is compared to a predefined variable threshold value and an earth fault is determined if this threshold value is exceeded.

2. Method according to claim 1, **characterised in that** an earth fault is determined if the amount of the space vector representation of the zero voltage (U_{0_RZ}) exceeds a predefined limit value.

3. Method according to claim 1 or 2, **characterised in that** the space vector representation of the zero voltage (U_{0_RZ}) and of the active component of the space vector representation of the zero currents (I_{01_RZ_WK}, I_{02_RZ}__{WK},..., I_{on_RZ_WK}) is not stored until the first time (t₁).

4. Method according to one of the preceding claims, **characterised in that** the difference between a local minimum and a local maximum of the space vector representations of the zero voltage (U_{0_RZ}) must have a predefined minimum value.

5. Method according to one of the preceding claims, **characterised in that** the procedure is aborted if the amount of the space vector representation of the zero voltage (U_{0_RZ}) exceeds a predefined range.

6. Method according to one of the preceding claims, **characterised in that** the trapezoidal sum is evaluated using a weighting function, **in that** the weighting function is increased upon occurrence of an earth fault on the corresponding outgoing circuit (A₁, A₂,..., Aₙ) by a first value up to maximally an upper limit value, **in that** upon occurrence of a transient earth fault on another outgoing circuit (A₁, A₂,..., Aₙ) the weighting function is reduced by the first value minimally to a lower limit value, and **in that** in the absence of a transient earth fault is modified by a second, smaller value in the direction of zero, wherein an outgoing circuit (A₁, A₂,..., Aₙ) is displayed as affected if the trapezoidal sum of said outgoing circuit evaluated using a weighting function exceeds a threshold value.

7. Method according to one of the preceding claims, **characterised in that** the variable threshold value is determined from the total capacity of the outgoing circuits (A₁, A₂,..., Aₙ) connected to a busbar.

8. Method according to claim 7, **characterised in that** the variable threshold value is determined as a particular percentage of the total capacity of the outgoing circuits (A₁, A₂,..., Aₙ) connected to a busbar (S₁, S₂, S₃, S₄).

## Revendications

1. Procédé d'identification d'une dérivation sujette à un défaut de fuite à la terre d'un réseau électrique triphasé, dans lequel on mesure et on met en mémoire la tension (U₀) homopolaire et les courants (I₀₁, I₀₂, ..., I₀ₙ) homopolaires se produisant à un point neutre, des dérivations (A₁, A₂, ..., Aₙ) à des instants récurrents périodiquement,
**caractérisé en ce que**
au moyen d'une transformation on détermine une représentation en vecteur d'espace de la tension (U_{0_RZ}) homopolaire et une composante active de la représentation en vecteur d'espace des courants (I_{01_RZ_WK}, I_{02_RZ_WK}, ..., I_{0N_RZ_WK}) homopolaires rapportée à la représentation en vecteur d'espace de la tension (U_{0_RZ}) homopolaire, **en ce qu'**après avoir constaté une fuite à la terre à un premier instant (t₁), on détermine un deuxième instant (t₂) où la représentation en vecteur d'espace de la tension (U_{0_RZ}) homopolaire a un minimum local et on détermine ensuite un troisième instant (t₃) où la représentation en vecteur d'espace de la tension (U_{0_RZ}) homopolaire a un maximum local, **en ce que** l'on détermine entre le deuxième instant (t₂) et le troisième instant (t₃) la somme trapèze des composantes actives de la représentation en vecteur d'espace des courants (I_{01_RZ_WK}, I_{02_RZ-WK}, ..., I_{0n_RZ_WK}) homopolaires et on en définit la dérivation sujette à une fuite à la terre, en comparant la somme trapèze des composantes actives de la représentation en vecteur d'espace des courants (I_{01_RZ_WK}, I_{02_RZ_WK}, ..., I_{0n_RZ_WK}) homopolaires à une valeur de seuil donnée à l'avance variable et en constatant une fuite à la terre si cette valeur de seuil est dépassée.

2. Procédé suivant la revendication 1, **caractérisé en ce que** l'on effectue la constatation d'une fuite à la terre si la valeur absolue de la représentation en vecteur d'espace de la tension (U_{0_RZ}) homopolaire dépasse une valeur limite donnée à l'avance.

3. Procédé suivant la revendication 1 ou 2, **caractérisé en ce que** l'on met en mémoire, seulement à partir du premier instant (t₁), la représentation en vecteur d'espace de la tension (U_{0_RZ}) homopolaire et des composantes actives de la représentation en vecteur d'espace des courants (I_{01_RZ_WK}, I_{02_RZ_WK}, ..., I_{0n_RZ_WK}) homopolaires.

4. Procédé suivant l'une des revendications précédentes, **caractérisé en ce que** la différence du minimum local et du maximum local des représentations en vecteur d'espace de la tension (U_{0_RZ}) homopolaire doit avoir une valeur minimum donnée à l'avance.

5. Procédé suivant l'une des revendications précédentes, **caractérisé en ce que** l'on interrompt le procédé si la valeur absolue de la représentation en vecteur d'espace de la tension (U_{0_RZ}) homopolaire dépasse une plage donnée à l'avance.

6. Procédé suivant l'une des revendications précédentes, **caractérisé en ce que** l'on évalue la somme trapèze par une fonction de pondération **en ce que** l'on élève d'une première valeur jusqu'à au maximum une valeur limite supérieure la fonction de pondération s'il se produit une fuite à la terre sur la dérivation (A₁, A₂, ..., Aₙ) correspondante, **en ce qu'**à l'apparition d'une fuite à la terre transitoire sur une autre dérivation (A₁, A₂, ..., Aₙ) on abaisse la fonction de pondération de la première valeur jusqu'à au minimum une valeur limite inférieure et **en ce qu'**en l'absence d'une fuite à la terre transitoire, on la modifie d'une deuxième valeur plus petite en direction de zéro, dans lequel on indique qu'une dérivation (A₁, A₂, ..., Aₙ) comme attaquée si la somme trapèze, évaluée par cette fonction de pondération, de cette dérivation dépasse une valeur de seuil.

7. Procédé suivant l'une des revendications précédentes, **caractérisé en ce que** l'on détermine la valeur de seuil variable à partir de la capacité d'ensemble des dérivations (A₁, A₂, ..., Aₙ) connectées à une barre collectrice.

8. Procédé suivant la revendication 7, **caractérisé en ce que** l'on fixe la valeur de seuil variable comme une valeur en pourcentage déterminée de la capacité d'ensemble des dérivations (A₁, A₂, ..., Aₙ) connectées à une barre (S₁, S₂, S₃, S₄) collectrice.
